# EUROPEAN PATENT APPLICATION

(11) **EP 4 207 271 A1**
(43) Date of publication of application: **05.07.2023**
(21) Application number: 21860307.4
(22) Date of filing: 23.08.2021
(51) Int. Cl.: H01L 23/498

(54) **CHIP PACKAGING MODULE AND ELECTRONIC DEVICE**

(30) Priority: 25.08.2020 CN 202010861960
(71) Applicant: Vivo Mobile Communication Co., Ltd., Dongguan, Guangdong 523863 (CN)
(72) Inventor: ZHANG, Yuegang, Dongguan, Guangdong 523863 (CN); LUO, Lei, Dongguan, Guangdong 523863 (CN)
(74) Representative: Conti, Marco
(86) International application number: PCT/CN2021/114027
(87) International publication number: WO 2022/042472

(57) **Abstract**

This application discloses a chip packaging module and an electronic device. The disclosed chip packaging module includes a bearing plate (100), a die (200), conductive adhesive (300), a connection reinforcing part (400), and a packaging layer (500), where the die (200) is electrically connected to the bearing plate (100) through the conductive adhesive (300), the connection reinforcing part (400) is connected to the bearing plate (100), at least part of the connection reinforcing part (400) is disposed in the conductive adhesive (300), and the packaging layer (500) is disposed on the bearing plate (100), and covers the die (200), the conductive adhesive (300), and the connection reinforcing part (400).

## Description

### CROSS-REFERENCE TO RELATED APPLICATIONS

This application claims priority to Chinese Patent Application No. 202010861960.2, filed with the China National Intellectual Property Administration on August 25, 2020 and entitled "CHIP PACKAGING MODULE AND ELECTRONIC DEVICE", which is incorporated herein by reference in its entirety.

### TECHNICAL FIELD

This application relates to the field of chip packaging technologies, and in particular, to a chip packaging module and an electronic device.

### BACKGROUND

With the rapid development of electronic devices, an electronic device is used more and more widely, and electronic devices such as a mobile phone and a tablet computer play an increasingly important role in people's work, life, entertainment, and other aspects. In addition, because a circuit board apparatus is the basis of an electronic device, a technology for packaging the circuit board apparatus becomes increasingly important with the increase of users' demands, to ensure stability and reliability of the electronic device during production and usage.

In the prior art, during a reflow soldering (reflow soldering, rising from 25°C to a peak temperature 260°C) process of a circuit board apparatus in an intelligent terminal device, because conductive adhesive and a bearing plate of a chip packaging module of the circuit board apparatus have different coefficients of thermal expansion and cold contraction, it is easy to cause delamination between the conductive adhesive and the bearing plate. As a result, a problem occurs in structural stability of the chip packaging module, which may even lead to a failure in an internal electrical connection of the chip packaging module.

### SUMMARY

This application discloses a chip packaging module and an electronic device, to resolve the problem that delamination easily occurs between conductive adhesive and a bearing plate during reflow soldering of a circuit board apparatus of an existing electronic device.

To resolve the above technical problem, the present invention is implemented as follows.

Embodiments of this application provide a chip packaging module and an electronic device.

According to a first aspect, this application discloses a chip packaging module, including a bearing plate, a die, conductive adhesive, a connection reinforcing part, and a packaging layer, where the die is electrically connected to the bearing plate through the conductive adhesive, the connection reinforcing part is connected to the bearing plate, at least part of the connection reinforcing part is disposed in the conductive adhesive, and the packaging layer is disposed on the bearing plate, and covers the die, the conductive adhesive, and the connection reinforcing part.

According to a second aspect, this application discloses an electronic device, including a housing, a circuit board disposed in the housing, and the above chip packaging module, where the chip packaging module is disposed on the circuit board and is electrically connected to the circuit board.

A technical solution used in this application can achieve the following beneficial effects.

The chip packaging module disclosed in this application includes a bearing plate, a die, conductive adhesive, a connection reinforcing part, and a packaging layer. The die is electrically connected to the bearing plate through the conductive adhesive; the connection reinforcing part is connected to the bearing plate; at least part of the connection reinforcing part is disposed in the conductive adhesive; and the packaging layer is disposed on the bearing plate, and covers the die, the conductive adhesive, and the connection reinforcing part. During reflow soldering of the chip packaging module, the connection reinforcing part can assist in a connection between the bearing plate and the conductive adhesive, so that the connection between the conductive adhesive and the bearing plate can be more stable, and delamination caused by different degrees of thermal expansion and cold contraction of the conductive adhesive and the bearing plate can be effectively alleviated. Therefore, structural stability of the chip packaging module can be improved.

### BRIEF DESCRIPTION OF DRAWINGS

To describe the technical solutions in the embodiments of this application or in the background art more clearly, the drawings required for describing the embodiments or the background art are described briefly below. Obviously, other drawings can be obtained by those of ordinary skill in the art based on these drawings without creative efforts.
FIG. 1 is a schematic structural diagram of a part of a chip packaging module according to an embodiment of this application;
FIG. 2 is a cutaway drawing of a chip packaging module according to an embodiment of this application; and
FIG. 3 is another cutaway drawing of a chip packaging module according to an embodiment of this application.

Reference numerals in the accompanying drawings are as follows:
100: bearing plate, 110: first pad, 120: second pad;
200: die;
300: conductive adhesive;
400: connection reinforcing part, 410: strip-shaped conductive elastic member, 411: first section, 412: second section, 413: third section, 420: spherical conductive elastic member;
500: packaging layer.

### DESCRIPTION OF EMBODIMENTS

To make the objectives, technical solutions, and advantages of this application clearer, the technical solutions of the present invention are described clearly and completely below with reference to the specific embodiments of the present invention and the corresponding accompanying drawings. Apparently, the described embodiments are merely some rather than all of the embodiments of the present invention. All other embodiments obtained by a person of ordinary skill in the art based on the embodiments of this application without creative efforts shall fall within the protection scope of this application.

The technical solutions disclosed in the embodiments of this application are described in detail below with reference to the accompanying drawings.

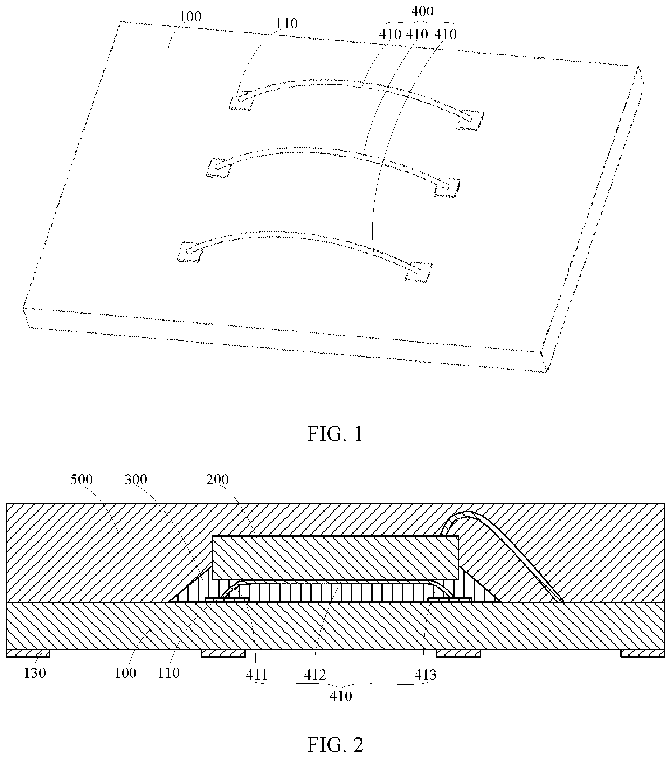

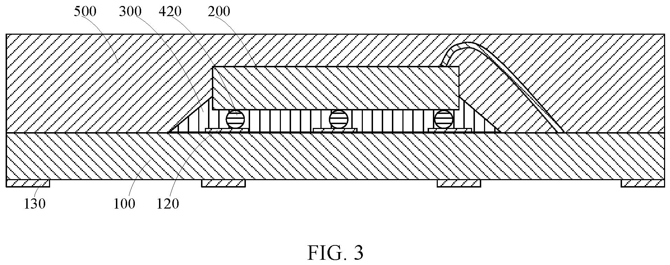

Referring to FIG. 1 to FIG. 3, an embodiment of this application discloses a chip packaging module. The disclosed chip packaging module is applied to an electronic device, and includes a bearing plate 100, a die 200, conductive adhesive 300, a connection reinforcing part 400, and a packaging layer 500.

The bearing plate 100 is a basic component of the chip packaging module, and can provide a mounting base for other components of the chip packaging module. The die 200 is bonded to the bearing plate 100 through the conductive adhesive 300, and can be electrically connected to the bearing plate 100 through the conductive adhesive 300.

The die 200 is a component that mainly implements a function of the chip packaging module, and may be bonded to the bearing plate 100 through the conductive adhesive 300. The connection reinforcing part 400 is connected to the bearing plate 100. At least part of the connection reinforcing part 400 may be disposed in the conductive adhesive 300.

The packaging layer 500 may be disposed on the bearing plate 100, so that the packaging layer 500 can cover the die 200, the conductive adhesive 300, and the connection reinforcing part 400 that are disposed on the bearing plate 100.

The chip packaging module disclosed in this application includes a bearing plate 100, a die 200, conductive adhesive 300, a connection reinforcing part 400, and a packaging layer 500. The die 200 is electrically connected to the bearing plate 100 through the conductive adhesive 300. The connection reinforcing part 400 is connected to the bearing plate 100. At least part of the connection reinforcing part 400 is disposed in the conductive adhesive 300. During reflow soldering of the chip packaging module, the connection reinforcing part 400 can assist in a connection between the bearing plate 100 and the conductive adhesive 300, so that a connection between the conductive adhesive 300 and the bearing plate 100 can be more stable, and delamination caused by different degrees of thermal expansion and cold contraction of the conductive adhesive 300 and the bearing plate 100 can be effectively alleviated. Therefore, structural stability of the chip packaging module can be improved.

In this embodiment of this application, the packaging layer 500 can cover the die 200, the conductive adhesive 300, and the connection reinforcing part 400 that are disposed on the bearing plate 100, so that the packaging layer 500 can perform a function of preventing water, dust, and shock. This improves an effect of protecting the die 200, the conductive adhesive 300, and the connection reinforcing part 400, and prevents external impurities (dust, liquid, or the like) from affecting reliability of the die 200, thereby improving reliability of the chip packaging module.

In this embodiment of this application, the connection reinforcing part 400 is disposed on the bearing plate 100, and at least part of the connection reinforcing part 400 is disposed in the conductive adhesive 300. Specifically, a part of the connection reinforcing part 400 may be disposed inside the conductive adhesive 300, and the rest part of the connection reinforcing part 400 may be disposed outside the conductive adhesive 300.

In an optional solution, the connection reinforcing part 400 is buried in the conductive adhesive 300, so that the connection reinforcing part 400 is completely disposed in the conductive adhesive 300, leading to a better reinforcing function of the connection reinforcing part 400. In addition, the connection reinforcing part 400 in the conductive adhesive 300 may also be used as a framework thereof. During a reflow soldering process of the chip packaging module disclosed in this application, the connection reinforcing part 400 used as the framework can prevent the conductive adhesive 300 from deforming when being heated, which is contributive to improving stability of bonding between the conductive adhesive 300 and the bearing plate 100 and between the conductive adhesive 300 and the die 200.

In this embodiment of this application, the connection reinforcing part 400 is connected to the bearing plate 100. Specifically, the connection reinforcing part 400 may be connected to the bearing plate 100 by means of bonding, riveting, or the like. Certainly, the connection may alternatively be implemented in another manner.

In an optional manner, a material of the connection reinforcing part 400 may be a conductive metal material. The connection reinforcing part 400 may be strongly welded to the bearing plate 100. The connection reinforcing part 400 may electrically connect the bearing plate 100 to the die 200. Specifically, delamination occurs between the conductive adhesive 300 and the bearing plate 100 during a reflow soldering process of the chip packaging module. The die 200 and the bearing plate 100 may be electrically connected to each other through the connection reinforcing part 400, which is contributive to improving stability of an electrical connection between the die 200 and the bearing plate 100.

Specifically, the connection reinforcing part 400 may be a strip-shaped conductive elastic member 410. The bearing plate 100 may be provided with first pads 110. Two ends of the strip-shaped conductive elastic member 410 may be correspondingly welded to the first pads 110. The strip-shaped conductive elastic member 410 may be bent in a first preset direction. The first preset direction is a direction from the bearing plate 100 to the die 200. Therefore, it is convenient to perform a certain pre-pressing function on the strip-shaped conductive elastic member 410 after the die 200 is mounted, which is contributive to an electrical connection between the strip-shaped conductive elastic member 410 and the die 200.

In the above connection manner, the strip-shaped conductive elastic member 410 needs to be in a pre-pressed state, and includes a first section 411, a second section 412, and a third section 413 that are formed via bending; a first end of the first section 411 is connected to the bearing plate 100; a second end of the first section 411 is connected to a first end of the second section 412; a second end of the second section 412 is connected to a first end of the third section 413; a second end of the third section 413 is connected to the bearing plate 100; and the die 200 is in contact with the second section 412. When in the pre-pressed state, the second section 412 has a larger area attached to the die 200, thereby implementing an electrical connection between the strip-shaped conductive elastic member 410 and the die 200.

As described above, the strip-shaped conductive elastic member 410 is welded to the bearing plate 100. There may be a plurality of strip-shaped conductive elastic members 410. The bearing plate 100 may be correspondingly provided with a plurality of first pads 110. The plurality of strip-shaped conductive elastic members 410 may be disposed in a second preset direction (for example, a length direction of the bearing plate 100) side by side, and may be in one-to-one welded connection with the plurality of first pads 110 disposed on the bearing plate 100. The plurality of strip-shaped conductive elastic members 410 can enhance a force of preventing the bearing plate 100 from deforming when being heated, thereby improving reliability of bonding of the conductive adhesive 300 to the bearing plate 100. This further ensures stability of an electrical connection between the bearing plate 100 and the die 200.

A specific structure of the strip-shaped conductive elastic member 410 may be a metal bar, a metal strip, or the like. In a preferred solution, the strip-shaped conductive elastic member 410 may be a metal sheet. The metal sheet uses a small amount of a metal material, and is of a sheet structure that is easy to bent, so that operating personnel can weld the metal sheet to the bearing plate 100 more conveniently, and strength of a connection between the connection reinforcing part 400 and the conductive adhesive 300 is increased.

Certainly, the connection reinforcing part 400 may alternatively be a spherical conductive elastic member 420. The spherical conductive elastic member 420 may be disposed on the bearing plate 100. Specifically, the bearing plate 100 may be provided with a second pad 120; and the spherical conductive elastic member 420 may be correspondingly welded to the second pad 120, to implement a connection between the spherical conductive elastic member 420 and the bearing plate 100.

In a further technical solution, a side of the spherical conductive elastic member 420 may be attached to the die 200. Therefore, the spherical conductive elastic member 420 may be electrically connected to the die 200, and may be welded to the bearing plate 100, so that the spherical conductive elastic member 420 can be electrically connected to the bearing plate 100, the bearing plate 100 and the die 200 can be electrically connected to each other through the spherical conductive elastic member 420, and the spherical conductive elastic member 420 can be completely disposed in the conductive adhesive 300. This is contributive to improving stability of an electrical connection between the die 200 and the bearing plate 100.

As described above, a side of the spherical conductive elastic member 420 may be attached to the die 200; there may be a plurality of spherical conductive elastic members 420; and the plurality of spherical conductive elastic members 420 may be distributed in an array. The plurality of spherical conductive elastic members 420 may be correspondingly welded to the second pad 120. An area of a region, welded to the plurality of spherical conductive elastic members 420, of the bearing plate 100 is enlarged, so that an amount of deformation in this region becomes smaller when the bearing plate 100 is heated. Therefore, the spherical conductive elastic members 420 can prevent the bearing plate 100 from deforming when being heated. This is contributive to alleviating delamination between the bearing plate 100 and the conductive adhesive 300, thereby being contributive to improving stability of bonding between the conductive adhesive 300 and the bearing plate 100 and between the conductive adhesive 300 and the die 200.

An embodiment of this application provides an electronic device based on the chip packaging module disclosed in the above embodiment of this application. The disclosed electronic device includes a housing, a circuit board disposed in the housing, and the chip packaging module according to the above embodiment. The chip packaging module may be disposed on the circuit board and electrically connected to the circuit board.

Specifically, the bearing plate 100 is provided with a third pad 130, and the third pad 130 is welded to the circuit board, so that the bearing plate 100 can be electrically connected to the circuit board.

In this embodiment of this application, after a reflow soldering process is performed on the chip packaging module and the circuit board disposed in the housing, an electrical connection between the chip packaging module and the circuit board disposed in the housing is normal and stable.

The above embodiments of this application focus on the differences between the embodiments. As long as different features of improvement in the embodiments are not contradictory, they can be combined to form a more preferred embodiment. Further descriptions are omitted herein for the purpose of brevity.

The embodiments described above are merely preferred embodiments of this application, which are not intended to limit this application. For a person skilled in the art, this application may have various changes and variations. Any modifications, equivalent substitutions, improvements, and the like made within the spirit and principle of this application should be included within the scope of the claims of this application.

## Claims

1. A chip packaging module, comprising: a bearing plate (100), a die (200), conductive adhesive (300), a connection reinforcing part (400), and a packaging layer (500), wherein the die (200) is electrically connected to the bearing plate (100) through the conductive adhesive (300), the connection reinforcing part (400) is connected to the bearing plate (100), at least part of the connection reinforcing part (400) is disposed in the conductive adhesive (300), and the packaging layer (500) is disposed on the bearing plate (100), and covers the die (200), the conductive adhesive (300), and the connection reinforcing part (400).

2. The chip packaging module according to claim 1, wherein the connection reinforcing part (400) is buried in the conductive adhesive (300).

3. The chip packaging module according to claim 1, wherein the connection reinforcing part (400) is welded to the bearing plate (100), and the connection reinforcing part (400) is electrically connected to the bearing plate (100) and the die (200).

4. The chip packaging module according to claim 1, wherein the connection reinforcing part (400) comprises a strip-shaped conductive elastic member (410), the bearing plate (100) is provided with first pads (110), two ends of the strip-shaped conductive elastic member (410) are correspondingly welded to the first pads (110), the strip-shaped conductive elastic member (410) is bent in a first preset direction, and the first preset direction is a direction from the bearing plate (100) to the die (200).

5. The chip packaging module according to claim 4, wherein the strip-shaped conductive elastic member (410) is in a pre-pressed state, and comprises a first section (411), a second section (412), and a third section (413) that are formed via bending, a first end of the first section (411) is connected to the bearing plate (100), a second end of the first section (411) is connected to a first end of the second section (412), a second end of the second section (412) is connected to a first end of the third section (413), a second end of the third section (413) is connected to the bearing plate (100), and the die (200) is in contact with and electrically connected to the second section (412).

6. The chip packaging module according to claim 4, wherein there are a plurality of strip-shaped conductive elastic members (410), and the plurality of strip-shaped conductive elastic members (410) are disposed in a second preset direction side by side.

7. The chip packaging module according to claim 1, wherein the connection reinforcing part (400) comprises a spherical conductive elastic member (420), the bearing plate (100) is provided with a second pad (120), and the spherical conductive elastic member (420) is welded to the bearing plate (100) through the second pad (120).

8. The chip packaging module according to claim 7, wherein a side of the spherical conductive elastic member (420) is electrically connected to the die (200), and the spherical conductive elastic member (420) is electrically connected to the bearing plate (100) through the second pad (120).

9. The chip packaging module according to claim 7, wherein there are a plurality of spherical conductive elastic members (420), and the plurality of spherical conductive elastic members (420) are distributed in an array.

10. An electronic device, comprising: a housing, a circuit board disposed in the housing, and the chip packaging module according to any one of claims 1 to 9, wherein the chip packaging module is disposed on and electrically connected to the circuit board.
